# EUROPEAN PATENT SPECIFICATION

(11) **EP 4 361 715 B1**
(45) Date of publication and mention of the grant of the patent: **25.02.2026**
(21) Application number: 23206728.0
(22) Date of filing: 30.10.2023
(51) Int. Cl.: G02F 1/1345, G02F 1/1362

(54) **DISPLAY DEVICE**
ANZEIGEVORRICHTUNG
DISPOSITIF D'AFFICHAGE

(30) Priority: 31.10.2022 KR 20220142581
(43) Date of publication of application: 01.05.2024
(73) Proprietor: Samsung Display Co., Ltd., Yongin-si, Gyeonggi-do 17113 (KR)
(72) Inventor: Kim, Yong Seog, Yongin-si, Gyeonggi-do (KR); Jin, Guanghai, Yongin-si, Gyeonggi-do (KR)
(74) Representative: Gulde & Partner

(56) References cited:
- KR-A- 20020 004 772
- KR-A- 20050 002 565
- US-A1- 2018 107 037

## Description

### BACKGROUND

### 1. Field of the Disclosure

The present disclosure relates to a display device.

### 2. Description of the Related Art

Today, display devices are becoming increasingly important as multimedia technology evolves. Accordingly, a variety of types of display devices such as organic light-emitting display (OLED) devices and liquid-crystal display (LCD) devices are currently used.

Display devices include a display panel such as an organic light-emitting display panel and a liquid-crystal display panel for displaying images. Among them, light-emitting display panel may include light-emitting elements. For example, light-emitting diodes (LEDs) may include an organic light-emitting diode (OLED) using an organic material as a fluorescent material, and an inorganic light-emitting diode using an inorganic material as a fluorescent material.

Such a display device may include a display area in which a plurality of pixels displaying images are disposed, and a non-display area around the display area. In the non-display area, a variety of lines such as gate lines and data lines for driving pixels may be arranged densely. In order to easily check and repair defects occurring during the processes in the non-display area, it is necessary to identify the line numbers of the gate lines and the data lines.

US 2018/0107037 Al is directed to a display device including a narrow bezel, wherein at least one of the gate wirings and the data wirings has a hole having an edge in the form representing multiple numbers.

### SUMMARY

Aspects of the present disclosure provide a display device in which line numbers of data lines and/or gate lines can be identified without increasing the distance between them.

It should be noted that objects of the present disclosure are not limited to the above-mentioned object; and other objects of the present disclosure will be apparent to those skilled in the art from the following descriptions.

According to an aspect of the present disclosure, a display device comprises a substrate, pixels disposed on the substrate, and a plurality of signal lines for applying a signal to the pixels, the plurality of signal lines disposed on the substrate, the signal lines being spaced apart from one another and extending parallel to a first direction, wide portions formed on one or more signal lines of the plurality of signal lines, each wide portion protruding from each of the one or more of signal lines in a second direction crossing the first direction, and an identification pattern for identifying line numbers of the plurality of signal lines, wherein the identification pattern includes the wide portions on the one or more of the signal lines, wherein the identification pattern is expressed by a group of the wide portions formed on each of at least two signal lines adjacent to each other in the second direction among the plurality of signal lines.

In an embodiment, the identification pattern may be a relief pattern.

In an embodiment, the identification pattern may be one of a symbol, a letter, a number, and a pattern.

In an embodiment, an orientation of the identification pattern may be parallel to the first direction.

In an embodiment, an orientation of the identification pattern may cross the first direction.

In an embodiment, the lines may be spaced apart from one another by a first width, and a width of each of the plurality of wide portions in the second direction may be smaller than the first width.

In an embodiment, the wide portions formed on each of at least two lines adjacent to each other in the second direction may be spaced apart from each other.

In an embodiment, the first width may range from 2 µm to 3 µm. Preferably, it may be 2,2 µm to 2,8 µm, more preferably 2,4 µm to 2,6 µm.

In an embodiment, the plurality of protrusion patterns may have a polygonal shape, and all interior angles of the plurality of protrusion patterns 2 µm to 3 µm obtuse angles.

In an embodiment, corners of each of the plurality of wide portions2 µm to 3 µm rounded.

According to an aspect of the present disclosure, a display device comprises a substrate, pixels disposed on the substrate, and a plurality of signal lines for applying a signal to the pixels on one or more signal lines of the plurality of signal lines, comprising a first line and a second line disposed on the substrate, extending parallel to a first direction and formed in different layers, wherein the first line includes a first wide portion protruding from the first line in the second direction crossing the first direction and spaced apart from one another in the first direction, wherein the second line includes a second wide portion protruding from the second line in the second direction and spaced apart from one another in the first direction, and wherein the first wide portion of the first line and the second wide portion of the second line adjacent to each other form an identification pattern for identifying line numbers of the plurality of signal lines.

In an embodiment, the second line may at least partially overlap the first line, and an insulating layer may be interposed between the first line and the second line.

In an embodiment, the first line and the first wide portion may be formed integrally, and the second line and the second wide portion are formed integrally.

In an embodiment, at least a portion of the first wide portion and at least a portion of the second wide portion may overlap each other in a thickness direction.

In an embodiment, the identification pattern may be a relief pattern.

In an embodiment, the identification pattern may be one of a symbol, a letter, a number, and a pattern.

In an embodiment, an orientation of the identification pattern may be parallel to the first direction.

In an embodiment, the first line and the second line may be spaced apart from each other by a first width in the second direction, and wherein a width of the second wide portion in the second direction is greater than that of the first width.

In an embodiment, the first line may cross a center of the first wide portion, and the second line may cross a center of the second wide portion.

According to an embodiment of the present disclosure, it is possible to identify line numbers of data lines and/or gate lines without increasing the distance between them.

It should be noted that effects of the present disclosure are not limited to those described above and other effects of the present disclosure will be apparent to those skilled in the art from the following descriptions.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view showing a display device according to an embodiment of the present disclosure.
FIG. 2 is a view showing a display device according to an embodiment of the present disclosure.
FIG. 3 is an enlarged view of area A1 of FIG. 2.
FIG. 4 is an enlarged view of a portion of a data line of FIG. 2.
FIG. 5 is a plan view showing identification patterns formed on data lines of a display device according to an embodiment.
FIG. 6 is an enlarged view of area A2 in FIG. 5.
FIG. 7 is a plan view showing identification patterns formed on data lines of a display device according to an embodiment.
FIG. 8 is a plan view showing identification patterns formed on data lines of a display device according to an embodiment.
FIG. 9 is a plan view showing identification patterns formed on data lines of a display device according to an embodiment.
FIG. 10 is a cross-sectional view taken along line X1 - X1' of FIG. 9.
FIG. 11 is a plan view showing identification patterns formed on data lines of a display device according to an embodiment.
FIG. 12 is a plan view showing identification patterns formed on data lines of a display device according to an embodiment.
FIG. 13 is a plan view showing identification patterns formed on data lines of a display device according to an embodiment.

### DETAILED DESCRIPTION OF THE EMBODIMENTS

The present disclosure will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

When a layer is referred to as being "on" another layer or substrate, it can be directly on the other layer or substrate, or intervening layers may be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Each of the features of the various embodiments of the present disclosure may be combined or combined with each other, in part or in whole, and technically various interlocking and driving are possible. Each embodiment may be implemented independently or may be implemented in some type of combination or association with another embodiment.

Embodiments of the present disclosure will hereinafter be described with reference to the attached drawings.

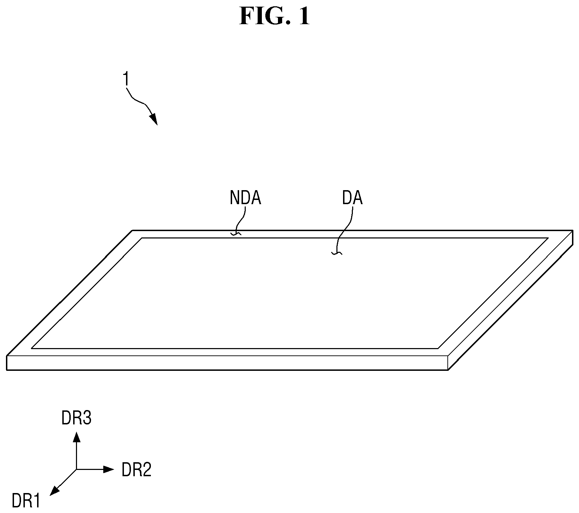

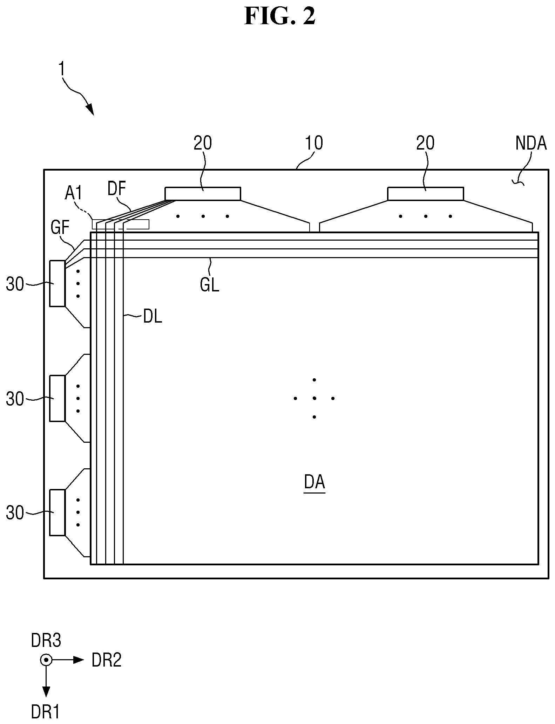

FIG. 1 is a perspective view showing a display device according to an embodiment of the present disclosure. FIG. 2 is a view showing a display device according to an embodiment of the present disclosure.

Referring to FIGS. 1 and 2, the display device 1 displays a moving image or a still image. A display device 1 may refer to any electronic device that provides a display screen. For example, the display device 1 may include a television set, a laptop computer, a monitor, an electronic billboard, the Internet of Things devices, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console and a digital camera, a camcorder, etc.

In FIG. 1, a first direction DR1, a second direction DR2 and a third direction DR3 are defined. The first direction DR1 and the second direction DR2 are perpendicular to each other, the first direction DR1 and the third direction DR3 are perpendicular to each other, and the second direction DR2 and the third direction DR3 are may be perpendicular to each other. The first direction DR1 may refer to the vertical direction in the drawings, the second direction DR2 may refer to the horizontal direction in the drawings, and the third direction DR3 may refer to the up- and-down direction, i.e., the thickness direction in the drawings. As used herein, a direction may refer to the direction indicated by the arrow as well as the opposite direction, unless specifically stated otherwise. If it is necessary to discern between such two opposite directions, one of the two directions may be referred to as "one side in the direction," while the other direction may be referred to as "the opposite side in the direction." In FIG. 1, the side indicated by an arrow indicative of a direction is referred to as one side in the direction, while the opposite side is referred to as the opposite side in the direction. It should be understood that the directions referred to in the embodiments are relative directions, and the embodiments are not limited to the directions mentioned.

In the following description of the surfaces of the display device 1 or the elements of the display device 1, the surfaces facing the side where images are displayed, i.e., in the third direction DR3, will be referred to as the upper surface, and the opposite surfaces will be referred to as the lower surface for convenience of illustration. It should be understood, however, that the present disclosure is not limited thereto. The surfaces and the opposite surface of the elements may be referred to as a front surface and a rear surface, respectively, or may be referred to as a first surface and a second surface, respectively. In addition, in the description of relative positions of the elements of the display device 1, one side in the second direction DR2 may be referred to as the upper side while the opposite side in the third direction DR3 may be referred to as the lower side.

The shape of the display device 1 may be modified in a variety of ways. For example, the display device 1 may have shapes such as a rectangle with longer lateral sides, a rectangle with longer vertical sides, a square, a quadrangle with rounded corners (vertices), other polygons, a circle, etc. In the example shown in FIG. 1, the display device 1 has a rectangular shape elongated in the second direction DR2, with the shorter sides in the first direction DR1 and the longer sides in the second direction DR2.

The display device 1 includes a display area DA for displaying an image, and a non-display area NDA adjacent to the display area DA. In the display area DA, pixels are disposed so that images are displayed. In the non-display area DA, no image is displayed. The display area DPA may be referred to as an active area, while the non-display area NDA may be referred to as an inactive area.

The display area DA may generally occupy the center of the display device 1. In some embodiments, the non-display area NDA may surround the display area DA, but the present disclosure is not limited thereto. The shape of the display area DA may be similar to the general shape of the display device 1.

The display device 1 according to the embodiment may include a substrate 10, data lines DL, gate lines GL, data fan-out lines DF, gate fan-out lines GF, a data driver integrated circuit 20, and a gate driver integrated circuit 30. Gate lines GL and data lines DL may both be referred to as "signal lines," as they both transmit signals for controlling the pixels of the display device 1.

The substrate 10 may work as a base of the display device 1. The substrate 10 may include, but is not limited to, glass, quartz or the like as a rigid material. For example, the substrate 10 may include polyimide having flexibility.

It should be noted that the display area DA and the non-display area NDA defined on the display device 1 may also be applied to the substrate 10. For example, the substrate 10 may include the display area DA generally occupying the center of the substrate 10, and the non-display area NDA around the display area DA. In some embodiments, the non-display area NDA may surround the display area DA, but the present disclosure is not limited thereto.

A plurality of pixels, and data lines DL and gate lines GL crossing the display area DA may be disposed on the display area DA of the substrate 10. Parts of the data lines DL and the gate lines GL, the data fan-out lines DF, the gate fan-out lines GF, the data driver integrated circuit 20, and the gate driver integrated circuit 30 may be disposed on the non-display area NDA of the substrate 10.

Each of the plurality of data lines DL may extend in the first direction DR1 and may be spaced apart from one another in the second direction DR2 on the display area DA of the substrate 10. The gate lines GL may extend in the second direction DR2 and may be spaced apart from one another in the first direction DR1. The data lines DL and the gate lines GL may be formed in the same layer or different layers.

On the non-display area NDA of the substrate 10, parts of the data lines DL may be connected to the data fan-out lines DF extending such that they obliquely cross the first direction DR1, and parts of the gate lines GL may be connected to the gate fan-out lines GF extending such that they obliquely cross the first direction DR1.

As used herein, when an element is referred to as being "connected" or "coupled" to another element, it can be directly connected or coupled to the element or intervening elements may be present. In addition, such elements may be understood as a single integrated element with one portion thereof connected to another portion. Moreover, when an element is referred to as being "connected" to another element, it may be in direct contact with the element and also electrically connected to the element.

In some embodiments, the data lines DL and the data fan-out lines DF may be integrally formed, and the gate lines GL and the gate fan-out lines GF may be integrally formed. It should be understood, however, that the present disclosure is not limited thereto. For example, the data lines DL and the data fan-out lines DF may be formed in different layers, and the gate lines GL and the gate fan-out lines GF may be formed in different layers. In the following description, the data lines DL and the data fan-out lines DF are integrally formed, and the gate lines GL and the gate fan-out lines GF are integrally formed for convenience of illustration.

The data fan-out lines DF may connect the data driver integrated circuit 20 with the data lines DL. The data fan-out lines DF may be connected to the data driver integrated circuit 20 such that they radially spread from the data driver integrated circuit 20.

Similarly, the gate fan-out lines GF may connect the gate driver integrated circuit 30 with the gate lines GL. The gate fan-out lines GF may be connected to the gate driver integrated circuit 30 such that they radially spread from the gate driver integrated circuit 30.

The data driver integrated circuit 20 may apply data signals transmitted to a plurality of pixels, and the gate driver integrated circuit 30 may apply gate signals transmitted to the plurality of pixels. For example, a data signal applied from the data driver integrated circuit 20 may be transferred to a pixel through a data fan-out line DF and a data line DL, and a gate signal applied from the gate driver integrated circuit 30 may be transferred to a pixel through a gate fan-out line GF and a gate line GL.

Incidentally, the signal lines (i.e., at least one of the data lines DL and the gate lines GL) are formed via a relatively early process in the processes of fabricating the display device 1. Therefore, defects may occur in the data lines DL and the gate lines GL during subsequent processes. Accordingly, in order to easily repair defects occurring in the data lines DL and the gate lines GL, it is necessary to accurately identify the location of a defective data line DL or a defective gate line GL.

Recently, as the resolution of the display device 1 increases, the density of pixels arranged in the display area DA, i.e., the pixel per inch (PPI) value, is increasing. As a result, the distance between the data lines DL and the gate lines GL connected to the pixels is reduced, and thus it is necessary to express the identification patterns for identifying the locations of the data lines DL and the gate lines GL without increasing the distance between the data lines DL and the gate lines GL.

Hereinafter, an identification pattern for identifying the locations of the data lines DL and the gate lines GL of the display device 1 according to an embodiment will be described.

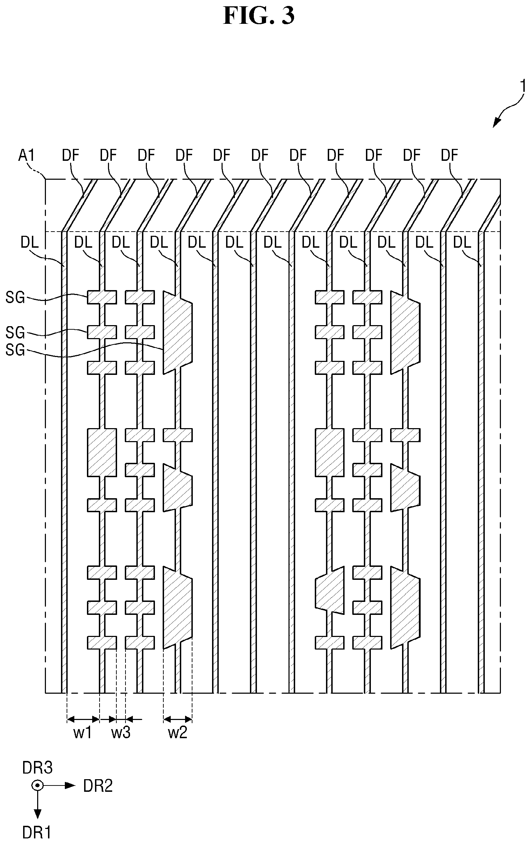

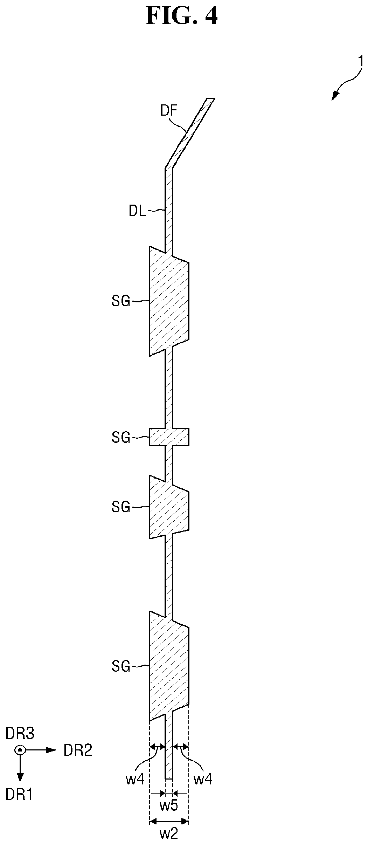

FIG. 3 is an enlarged view of area A1 of FIG. 2. FIG. 4 is an enlarged view of a portion of a data line of FIG. 2.

Referring to FIGS. 3 and 4 in conjunction with FIG. 2, wide portions SG may protrude from the data lines DL in the second direction DR2 in the display device 1 according to the embodiment of the present disclosure, so that they may form a group for expressing an identification pattern for identifying the locations of the data lines DL. In other words, the data lines DL may have different line widths, and portions with larger widths may become the wide portions SG.

Although the data lines DL are described in FIGS. 3 and 4, it is to be understood that the wide portions SG on the gate lines GL (see FIG. 2) may form an identification pattern for identifying the location of the gate lines GL, similarly to the data lines DL. For simplicity, the structure of the data lines DL will be described, with the understanding that identification pattern may be formed on the gate lines GL in a similar manner.

The data lines DL may extend in the first direction DR1 and may be arranged in the second direction DR2 such that they are spaced apart from one another. The data lines DL may be spaced apart from one another in the second direction DR2 with a first width w1. In some embodiments, the first width w1 may range between approximately 2 µm and 3 µm.

In some embodiments, all the data lines DL may be formed in the same layer, but the present disclosure is not limited thereto. In the example shown in FIG. 3, the data lines DL are formed in the same layer.

The data lines DL include the wide portions SG. The wide portions SG formed on the data lines DL may have a second width w2 in the second direction DR2 smaller than the first width w1. In some embodiments, the second width w2 may range between approximately 1.4 µm and 1.6 µm.

A plurality of wide portions SG may be formed on one data line DL. The wide portions SG may protrude from the data line DL on both sides in the second direction DR2 and may be spaced apart from one another in the first direction DR1.

Since the wide portions SG formed on one data line DL form a group with the wide portions SG formed on adjacent data lines DL to form an identification pattern, the wide portions SG may have a variety of shapes depending on the shape of the identification pattern. For example, the wide portions SG may have a variety of shapes in accordance with an identification pattern to be displayed, such as a rectangular shape having longer sides in the second direction DR2 and shorter sides in the first direction DR1 when viewed from the top, or a rectangular shape having longer sides in the first direction DR1 and shorter sides in the second direction DR2 when viewed from the top.

The identification pattern formed by the wide portions SG may express one of a symbol, a letter, a number and a pattern. In the example shown in FIG. 3, the identification pattern is expressed in the form of numbers. In some embodiments, the identification pattern may be expressed by the group of wide portions SG formed on three data lines DL, but the number of data lines DL required to express the identification pattern is not particularly limited. In the example shown in FIG. 3, a group of wide portions SG formed on three data lines DL expresses 353 and 359 in the form of numbers as the identification pattern. The identification pattern formed by relief pattern. For example, the wide portions SG is a relief pattern.

In some embodiments, the orientation of the identification pattern may be parallel to the direction in which the data lines DL extend, but the present disclosure is not limited thereto. In the example shown in FIG. 3, the orientation of the numbers of 353 and 359 as the identification pattern is parallel to the first direction DR1 in which the data lines DL extend.

As described above, when the data lines DL are formed in the same layer, the wide portions SG formed on the adjacent data lines DL are spaced apart from one another in the second direction DR2 by a third width w3, and thus they are not in contact with each other. In some embodiments, the third width w3 may range between approximately 0.2 µm and 1.2 µm.

In some embodiments, the data lines DL may appear to extend through the central portions of a plurality of wide portions SG that are arranged in the first direction DR1. Accordingly, the plurality of wide portions SG may protrude from the data lines DL on both sides by the same distance in the second direction DR2, the distance being a fourth width w4. The data lines DL may have a fifth width w5 smaller than the second width w2 of the protrusion patterns SG. In some embodiments, the fifth width w5 may range between 1 µm and 2 µm. If the fifth width w5 is 1 µm, the fourth width w4 may range from 0.2 µm to 0.3 µm.

The identification pattern for identifying the location of the data lines DL which is formed by the group of wide portions SG protruding from the data lines DL may be located in the non-display area NDA. Accordingly, the remaining portion of data lines DL extending in the display area DA may have no change in the line width.

With the above-described configuration, the identification pattern can be formed without changing the distance between the data lines DL (or Gate lines). Therefore, even though the pixel per unit inch (PPI) value increases, the identification pattern for identifying the location of the data lines DL (or Gate lines) can be expressed without increasing the distance between the data lines DL (or Gate lines).

Hereinafter, display device according to other embodiments of the present disclosure will be described. In the following description, the same or similar elements will be denoted by the same or similar reference numerals, and redundant descriptions will be omitted or briefly described.

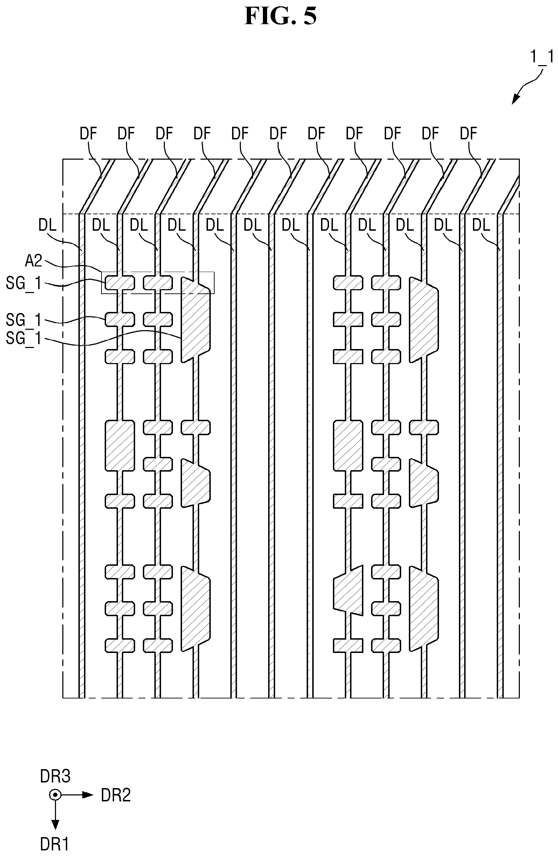

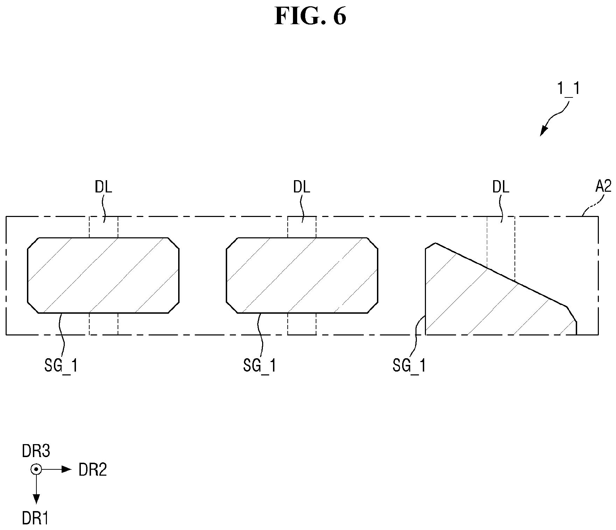

FIG. 5 is a plan view showing identification patterns formed on data lines of a display device according to an embodiment. FIG. 6 is an enlarged view of area A2 in FIG. 5.

Referring to FIGS. 5 and 6, wide portions SG_1 of a display device 1_1 according to this embodiment may be formed in polygonal shapes with right-angle or acute-angle corners cut off, such that all interior angles of the wide portions SG_1 may be obtuse angles of 90° or more.

If the interior angle of the wide portions SG_1 is an acute angle of less than 90°, it is likely that damage caused by static electricity will occur in subsequent processes after the process of forming the data lines DL. Therefore, by forming the wide portions SG_1 to have obtuse interior angles, such damage caused by static electricity can be prevented or reduced.

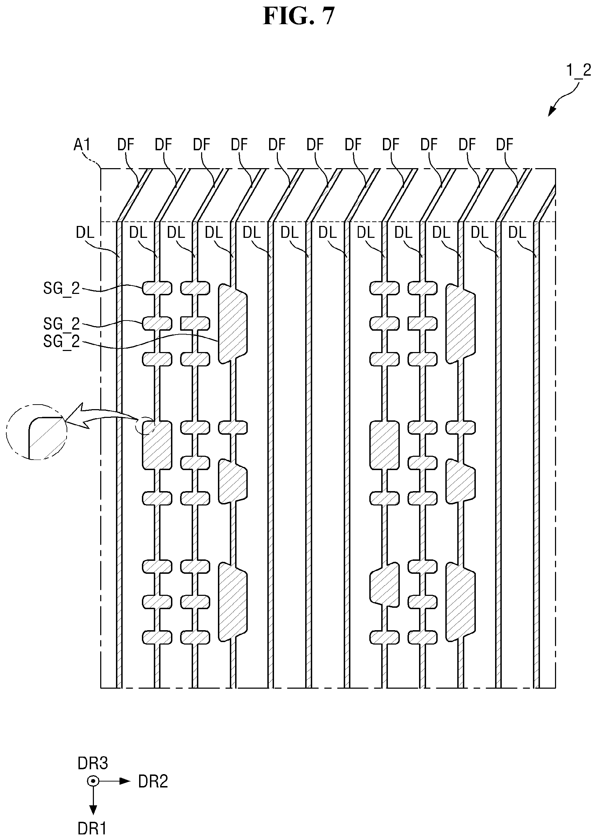

FIG. 7 is a plan view showing identification patterns formed on data lines of a display device according to an embodiment.

Referring to FIG. 7, the edges of the wide portions SG_2 of a display device 1_2 according to this embodiment may be formed in a rounded or curved shape. With the curved edges of the wide portions SG_2, it is possible to effectively reduce damage caused by static electricity that may occur in subsequent processes after the process of forming the data lines DL.

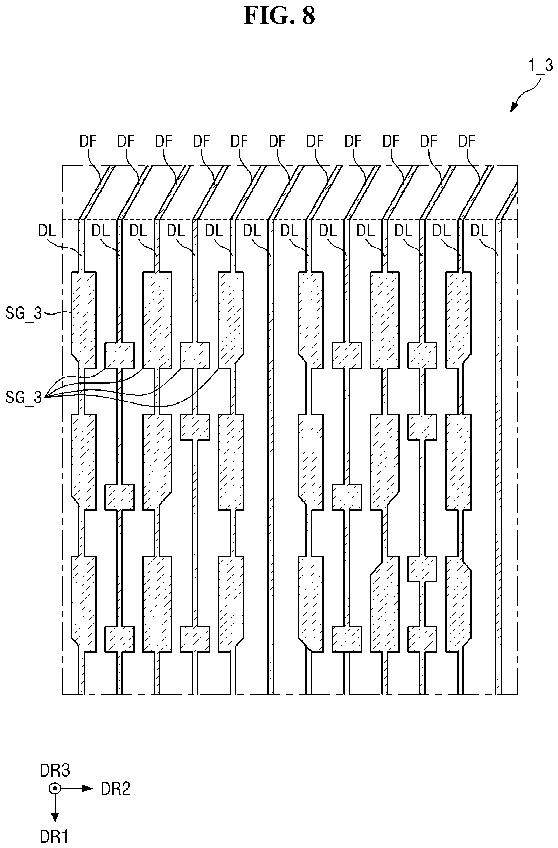

FIG. 8 is a plan view showing identification patterns formed on data lines of a display device according to an embodiment.

In the example shown in FIG. 8, the orientation of the identification pattern expressed by the groups formed by the wide portions SG_3 of a display device 1_3 according to this embodiment may be changed. For example, the orientation of the identification pattern expressed by the groups of the wide portions SG_3 may be non-parallel to the direction in which the data lines DL extend, i.e., the first direction DR1. For example, the identification pattern expressed by the groups of the wide portions SG_3 may be such that the orientation of the number 3 is in the second direction DR2 (sideways with respect to the figure).

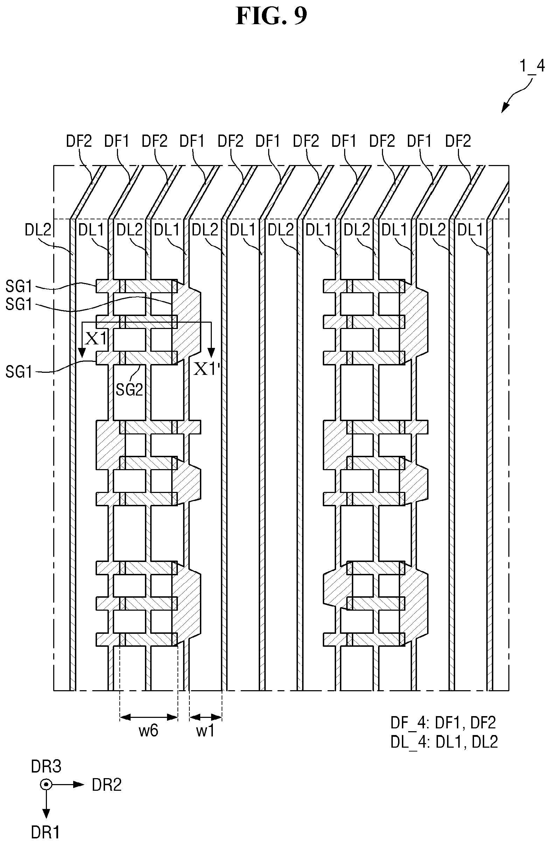

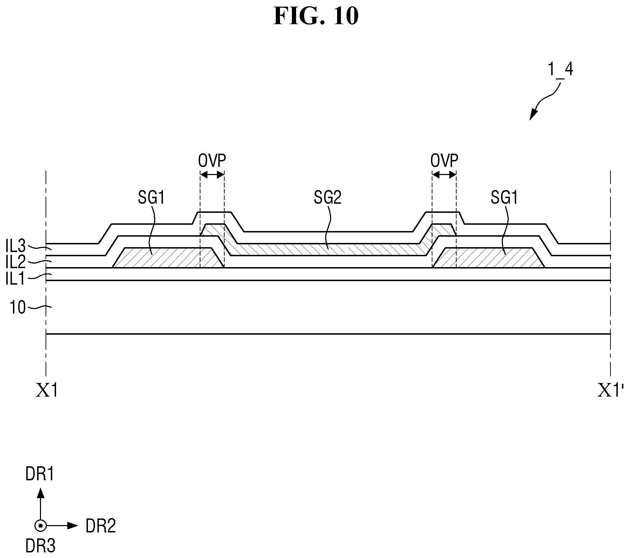

FIG. 9 is a plan view showing identification patterns formed on data lines of a display device according to an embodiment. FIG. 10 is a cross-sectional view taken along line X1 - X1' of FIG. 9.

In the example shown in FIGS. 9 and 10, protrusion patterns SG1 and SG2 of a display device 1_4 according to this embodiment may be formed in different layers and may overlap each other at least partially in the thickness direction (DR3).

According to this embodiment, data lines DL_4 may include first data lines DL1 and second data lines DL2 formed in different layers, and the first data lines DL1 and the second data lines DL2 may be alternately arranged in the second direction DR2. The distance between the first data lines DL1 and the second data lines DL2 in the second direction DR2 may be the first width w1 described above with reference to FIG. 3.

In some embodiments, the second data lines DL2 may be in a layer that is disposed on the layer of the first data lines DL1. In the example shown in FIGS. 9 and 10, the second data lines DL2 are disposed on the first data lines DL1, and an insulating layer is interposed between the second data lines DL2 and the first data lines DL1.

In addition, according to this embodiment, data fan-out lines DF_4 may include first data fan-out lines DF1 and second data fan-out lines DF2 formed in different layers, and the first data fan-out lines DF1 and the second data fan-out lines DF2 may be alternately arranged in the second direction DR2.

In some embodiments, the first data fan-out lines DF1 and the first data lines DL1 may be formed in the same layer, and the second data fan-out lines DF2 and the second data lines DL2 may be formed in the same layer. It should be understood, however, that the present disclosure is not limited thereto.

The first data fan-out lines DF1 and the first data lines DL1 may be connected with each other, and the second data fan-out lines DF2 and the second data lines DL2 may be connected with each other, as illustrated in FIG. 9. The connection relationship between the first data fan-out lines DF1 and the first data lines DL1 and the connection relationship between the second data fan-out lines DF2 and the second data lines DL2 may be substantially identical to the connection relationship between the data fan-out lines DF and the data lines DL described above with reference to FIG. 2; and, therefore, the redundant descriptions will be omitted.

First wide portions SG1 protruding in the second direction DR2 may be formed on the first data lines DL1. The first data lines DL1 and the first wide portions SG1 are substantially identical to the data lines DL and the wide portions SG described above with reference to FIG. 3; and, therefore, the redundant descriptions will be omitted.

Second wide portions SG2 protruding in the second direction DR2 may be formed on the second data lines DL2. The second wide portions SG2 may at least partially overlap the first wide portions SG1 formed on the adjacent first data lines DL1. As described above, since the insulating layer is interposed between the second data lines DL2 and the first data lines DL1, even though the second wide portions SG2 formed on the second data lines DL2 partially overlap the first wide portions SG1 formed on the first data lines DL1, the second data lines DL2 and the first data lines may be electrically insulated from each other.

In some embodiments, the identification pattern formed by the first wide portions SG1 and the second wide portions SG2 may be expressed as one of a symbol, a letter, a number and a pattern. In the example shown in FIG. 9, the identification pattern is expressed in the form of numbers. In some embodiments, the identification pattern may be expressed by groups of wide portions SG1 and SG2 formed on three data lines DL_4, but the number of data lines DL_4 required to express the identification pattern is not particularly limited. In the example shown in FIG. 9, the groups of the first wide portions SG1 and the second wide portions SG2 formed on two first data lines DL1 and a second data line DL2 disposed therebetween express the numbers of 353 and 359 as the identification pattern.

Incidentally, the second wide portions SG2 may have a sixth width w6 greater than the first width w1, which is the distance between the first data lines DL1 and the second data lines DL2. Accordingly, the second wide portions SG2 may at least partially overlap with the first wide portions SG1.

Referring to FIG. 10, the first protruding pattern SG1 may be disposed on a first insulating layer IL1 formed on the entire surface of the substrate 10, a second insulating layer IL2 may be disposed on the first protruding pattern SG1, a second protruding pattern SG2 may be disposed on the second insulating layer IL2, and a third insulating layer IL3 may be disposed on the second protruding pattern SG2. The second protruding pattern SG2 may extend in the second direction DR2 to form an overlapping portion OVP where it overlaps in the third direction DR3 with an end of the first protruding pattern SG1 in the second direction DR2.

With the above-described configuration, the identification pattern expressed by the groups of the first and second wide portions SG1 and SG2 can be in a complete shape without any gap, so that the line number of the data lines DL_4 can be easily identified.

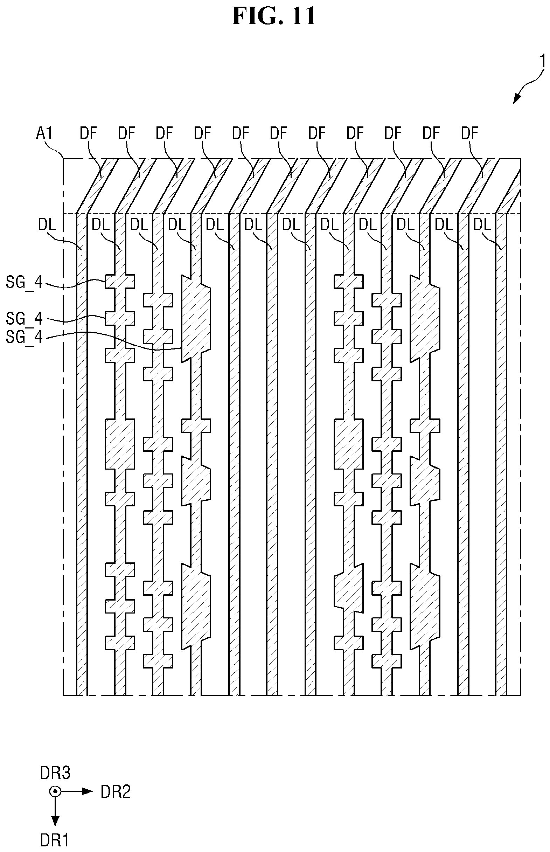

FIG. 11 is a plan view showing identification patterns formed on data lines of a display device according to an embodiment.

Referring to FIG. 11, wide portions SG_4 of adjacent data lines DL may not be arranged side-by-side in the second direction DR2. In the example of FIG. 11, the wide portions SG_4 of neighboring data lines DL are arranged in a staggered manner. In this manner, it is possible to prevent a short circuit between the adjacent data lines DL. In addition, it is possible to suppress the coupling between the adjacent data lines DL, and thus it is possible to reduce one data line DL among the adjacent data lines DL that are affected by the other data line DL.

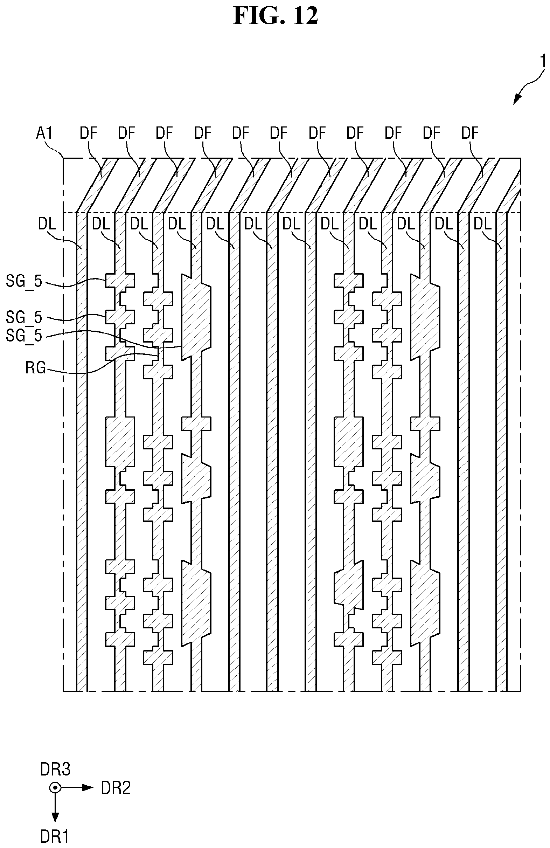

FIG. 12 is a plan view showing identification patterns formed on data lines of a display device according to an embodiment.

Referring to FIG. 12, protruding pattern SG_5 of one data line DL among adjacent data lines DL may be arranged side-by-side with a depressed pattern (or recess pattern RG) of another data line DL in the second direction DR2. In this manner, it is possible to prevent a short circuit between adjacent data lines DL. In addition, it is possible to suppress the coupling between the adjacent data lines DL, and thus it is possible to reduce one data line DL among the adjacent data lines DL that are affected by the other data line DL.

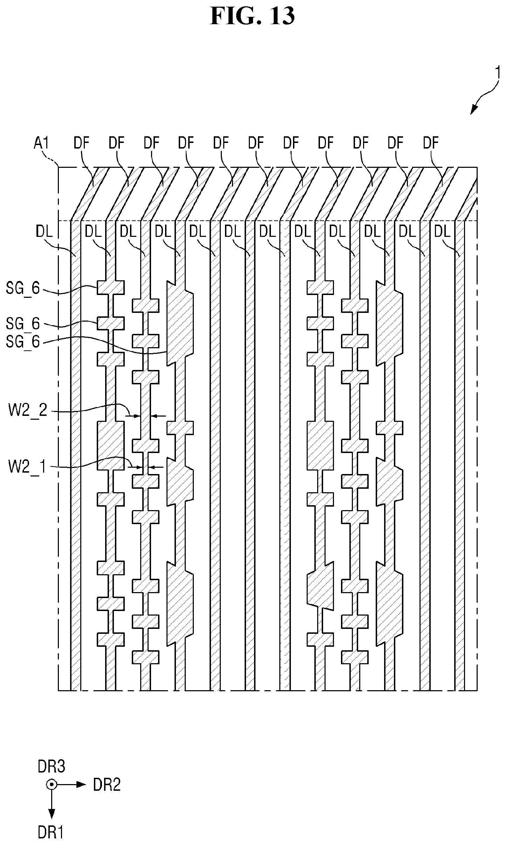

FIG. 13 is a plan view showing identification patterns formed on data lines of a display device according to an embodiment.

Referring to FIG. 13, in order to improve the visibility of wide portions SG_6, a line width W1_2 of each of the data lines DL between adjacent wide portions SG_6 in the first direction DR1 may be larger than a line width W2_1 of the other portions.

In concluding the detailed description, those skilled in the art will appreciate that many variations and modifications can be made to the preferred embodiments without substantially departing from the principles of the present invention as defined in the appended claims. Therefore, the disclosed preferred embodiments of the invention are used in a generic and descriptive sense only and not for purposes of limitation.

## Claims

1. A display device (1) comprising:
a substrate (10);
pixels disposed on the substrate (10);
a plurality of signal lines (DL) for applying a signal to the pixels, the plurality of signal lines (DL) disposed on the substrate (10), the signal lines (DL) being spaced apart from one another and extending parallel to a first direction (DR1);
wide portions (SG) formed on one or more signal lines (DL) of the plurality of signal lines (DL), each wide portion (SG) protruding from each of the one or more of signal lines (DL) in a second direction (DR2) crossing the first direction (DR1); and
an identification pattern for identifying line numbers of the plurality of signal lines (DL),
wherein the identification pattern includes the wide portions (SG) on the one or more the signal lines (DL),
**characterised in that**
the identification pattern is expressed by a group of the wide portions (SG) formed on each of at least two signal lines (DL) adjacent to each other in the second direction (DR2) among the plurality of signal lines (DL).

2. The display device (1) of claim 1, wherein the identification pattern is a relief pattern; and/or wherein the identification pattern is one of a symbol, a letter, a number, and a pattern.

3. The display device (1) of claim 1 or 2, wherein an orientation of the identification pattern is parallel to the first direction (DR1), or wherein an orientation of the identification pattern crosses the first direction (DR1).

4. The display device (1) of any one of the preceding claims, wherein the signal lines (DL) are spaced apart from one another by a first width (w1), and
a width (w2) of each of the plurality of wide portions (SG) in the second direction (DR2) is smaller than the first width (w1).

5. The display device (1) of any one of the preceding claims, wherein the wide portions (SG) formed on each of at least two signal lines (DL) adjacent to each other in the second direction (DR2) are spaced apart from each other.

6. The display device (1) of claim 4, wherein the first width (w1) ranges from 2 µm to 3 µm.

7. The display device (1) of any of the preceding claims, wherein the plurality of wide portions (SG) has a polygonal shape, and all interior angles of the plurality of wide portions (SG) are obtuse angles; and/or wherein corners of each of the plurality of wide portions (SG) are rounded.

8. A display device (1) comprising:
a substrate (10);
pixels disposed on the substrate (10); and
a plurality of signal lines (DL) for applying a signal to the pixels on one or more signal lines (DL) of the plurality of signal lines (DL), comprising a first line (DL1) and a second line (DL2) disposed on the substrate (10), extending parallel to a first direction (DR1),
wherein the first line (DL1) includes a first wide portion (SG1) protruding from the first line (DL1) in a second direction (DR2) crossing the first direction (DR1),
wherein the second line (DL2) includes a second wide portion (SG2) protruding from the second line (DL2) in the second direction (DR2),
**characterised in that**
the first line and the second line are formed in different layers, and **in that** the first wide portion (SG1) of the first line (DL1) and the second wide portion (SG2) of the second line (DL2) adj acent to each other form an identification pattern for identifying line numbers of the plurality of signal lines (DL).

9. The display device (1) of claim 8, wherein the second line (DL2) at least partially overlaps the first line (DL2), and
an insulating layer (IL1, IL2, IL3) is interposed between the first line (DL1) and the second line (DL2).

10. The display device (1) of claim 8 or 9, wherein the first line (DL1) and the first wide portion (SG1) are formed integrally, and
the second line (DL2) and the second wide portion (SG2) are formed integrally.

11. The display device (1) of any of claims 8 to 10, wherein at least a portion of the first wide portion (SG1) and at least a portion of the second wide portion (SG2) overlap each other in a thickness direction (DR3).

12. The display device (1) of any of claims 8 to 11, wherein the identification pattern is a relief pattern; and/or wherein the identification pattern is one of a symbol, a letter, a number, and a pattern.

13. The display device (1) of any of claims 8 to 12, wherein an orientation of the identification pattern is parallel to the first direction (DR1).

14. The display device (1) of any of claims 8 to 13, wherein the first line (DL1) and the second line (DL2) are spaced apart from each other by a first width (w1) in the second direction (DR2), and
wherein a width (w6) of the second wide portion (SG2) in the second direction (DR2) is greater than that of the first width (w1).

15. The display device (1) of any of claims 8 to 14, wherein the first line (DL1) extends through a center of the first wide portion (SG1), and
the second line (DL2) extends through a center of the second wide portion (SG2).

## Patentansprüche

1. Anzeigevorrichtung (1), umfassend:
ein Substrat (10);
auf dem Substrat (10) angeordnete Pixel;
mehrere Signalleitungen (DL) zum Anlegen eines Signals an die Pixel, wobei die mehreren Signalleitungen (DL) auf dem Substrat (10) angeordnet sind, wobei die Signalleitungen (DL) voneinander beabstandet sind und sich parallel zu einer ersten Richtung (DR1) erstrecken;
breite Abschnitte (SG), die auf einer oder mehreren Signalleitungen (DL) der mehreren Signalleitungen (DL) ausgebildet sind, wobei jeder breite Abschnitt (SG) von jeder der einen oder mehreren Signalleitungen (DL) in einer zweiten Richtung (DR2) vorsteht, die die erste Richtung (DR1) kreuzt; und
ein Identifikationsmuster zum Identifizieren von Leitungsnummern der mehreren Signalleitungen (DL), wobei das Identifikationsmuster die breiten Abschnitte (SG) auf der einen oder den mehreren Signalleitungen (DL) umfasst,
**dadurch gekennzeichnet, dass**
das Identifikationsmuster durch eine Gruppe der breiten Abschnitte (SG) ausgedrückt wird, die auf jeder von mindestens zwei Signalleitungen (DL) unter den mehreren Signalleitungen (DL) ausgebildet sind, die in der zweiten Richtung (DR2) nebeneinander liegen.

2. Anzeigevorrichtung (1) nach Anspruch 1, wobei das Identifikationsmuster ein Reliefmuster ist; und/oder wobei das Identifikationsmuster eines von einem Symbol, einem Buchstaben, einer Zahl und einem Muster ist.

3. Anzeigevorrichtung (1) nach Anspruch 1 oder 2, wobei eine Ausrichtung des Identifikationsmusters parallel zur ersten Richtung (DR1) ist oder wobei eine Ausrichtung des Identifikationsmusters die erste Richtung (DR1) kreuzt.

4. Anzeigevorrichtung (1) nach einem der vorstehenden Ansprüche, wobei die Signalleitungen (DL) voneinander um eine erste Breite (w1) beabstandet sind und
eine Breite (w2) jedes der mehreren breiten Abschnitte (SG) in der zweiten Richtung (DR2) kleiner ist als die erste Breite (w1).

5. Anzeigevorrichtung (1) nach einem der vorstehenden Ansprüche, wobei die breiten Abschnitte (SG), die auf jeder von mindestens zwei in der zweiten Richtung (DR2) nebeneinander liegenden Signalleitungen (DL) ausgebildet sind, voneinander beabstandet sind.

6. Anzeigevorrichtung (1) nach Anspruch 4, wobei die erste Breite (w1) im Bereich von 2 µm bis 3 µm liegt.

7. Anzeigevorrichtung (1) nach einem der vorstehenden Ansprüche, wobei die mehreren breiten Abschnitte (SG) eine polygonale Form aufweisen und alle Innenwinkel der mehreren breiten Abschnitte (SG) stumpfe Winkel sind; und/oder wobei die Ecken jedes der mehreren breiten Abschnitte (SG) abgerundet sind.

8. Anzeigevorrichtung (1), umfassend:
ein Substrat (10);
auf dem Substrat (10) angeordnete Pixel; und
mehrere Signalleitungen (DL) zum Anlegen eines Signals an die Pixel auf einer oder mehreren Signalleitungen (DL) der mehreren Signalleitungen (DL), umfassend eine erste Leitung (DL1) und eine zweite Leitung (DL2), die auf dem Substrat (10) angeordnet sind und sich parallel zu einer ersten Richtung (DR1) erstrecken,
wobei die erste Leitung (DL1) einen ersten breiten Abschnitt (SG1) umfasst, der von der ersten Leitung (DL1) in einer zweiten Richtung (DR2) vorsteht, die die erste Richtung (DR1) kreuzt,
wobei die zweite Leitung (DL2) einen zweiten breiten Abschnitt (SG2) umfasst, der von der zweiten Leitung (DL2) in der zweiten Richtung vorsteht (DR2),
**dadurch gekennzeichnet, dass**
die erste Leitung und die zweite Leitung in unterschiedlichen Schichten ausgebildet sind, und dass
der erste breite Abschnitt (SG1) der ersten Leitung (DL1) und der zweite breite Abschnitt (SG2) der zweiten Leitung (DL2), die aneinander angrenzen, ein Identifikationsmuster zum Identifizieren von Leitungsnummern der mehreren Signalleitungen (DL) bilden.

9. Anzeigevorrichtung (1) nach Anspruch 8, wobei die zweite Leitung (DL2) die erste Leitung (DL2) zumindest teilweise überlappt und
eine Isolierschicht (IL1, IL2, IL3) zwischen der ersten Leitung (DL1) und der zweiten Leitung (DL2) angeordnet ist.

10. Anzeigevorrichtung (1) nach Anspruch 8 oder 9, wobei die erste Leitung (DL1) und der erste breite Abschnitt (SG1) integral ausgebildet sind und
die zweite Leitung (DL2) und der zweite breite Abschnitt (SG2) integral ausgebildet sind.

11. Anzeigevorrichtung (1) nach einem der Ansprüche 8 bis 10, wobei sich mindestens ein Abschnitt des ersten breiten Abschnitts (SG1) und mindestens ein Abschnitt des zweiten breiten Abschnitts (SG2) in einer Dickenrichtung (DR3) überlappen.

12. Anzeigevorrichtung (1) nach einem der Ansprüche 8 bis 11, wobei das Identifikationsmuster ein Reliefmuster ist; und/oder wobei das Identifikationsmuster eines von einem Symbol, einem Buchstaben, einer Zahl und einem Muster ist.

13. Anzeigevorrichtung (1) nach einem der Ansprüche 8 bis 12, wobei eine Ausrichtung des Identifikationsmusters parallel zur ersten Richtung (DR1) ist.

14. Anzeigevorrichtung (1) nach einem der Ansprüche 8 bis 13, wobei die erste Linie (DL1) und die zweite Linie (DL2) in der zweiten Richtung (DR2) um eine erste Breite (w1) voneinander beabstandet sind und
wobei eine Breite (w6) des zweiten breiten Abschnitts (SG2) in der zweiten Richtung (DR2) größer ist als die der ersten Breite (w1).

15. Anzeigevorrichtung (1) nach einem der Ansprüche 8 bis 14, wobei sich die erste Linie (DL1) durch eine Mitte des ersten breiten Abschnitts (SG1) erstreckt und
sich die zweite Linie (DL2) durch eine Mitte des zweiten breiten Abschnitts (SG2) erstreckt.

## Revendications

1. Dispositif d'affichage (1) comprenant :
un substrat (10) ;
des pixels disposés sur le substrat (10) ;
une pluralité de lignes de signal (DL) permettant d'appliquer un signal aux pixels, la pluralité de lignes de signal (DL) étant disposées sur le substrat (10), les lignes de signal (DL) étant espacées les unes des autres et s'étendant parallèlement à une première direction (DR1) ;
des parties larges (SG) formées sur une ou plusieurs lignes de signal (DL) de la pluralité de lignes de signal (DL), chaque partie large (SG) faisant saillie à partir de chacune des une ou plusieurs lignes de signal (DL) dans une seconde direction (DR2) traversant la première direction (DR1) ; et
un modèle d'identification permettant d'identifier des numéros de ligne de la pluralité de lignes de signal (DL),
dans lequel le motif d'identification inclut les parties larges (SG) sur les une ou plusieurs lignes de signal (DL),
**caractérisé en ce que** le motif d'identification est exprimé par un groupe des parties larges (SG) formées sur chacune d'au moins deux lignes de signal (DL) adjacentes l'une à l'autre dans la seconde direction (DR2) parmi la pluralité de lignes de signal (DL).

2. Dispositif d'affichage (1) selon la revendication 1, dans lequel le motif d'identification est un motif en relief ; et/ou dans lequel le motif d'identification est l'un parmi un symbole, une lettre, un nombre et un motif.

3. Dispositif d'affichage (1) selon la revendication 1 ou 2, dans lequel une orientation du motif d'identification est parallèle à la première direction (DR1), ou dans lequel une orientation du motif d'identification traverse la première direction (DR1).

4. Dispositif d'affichage (1) selon l'une quelconque des revendications précédentes, dans lequel les lignes de signal (DL) sont espacées les unes des autres d'une première largeur (w1), et
une largeur (w2) de chacune de la pluralité de parties larges (SG) dans la seconde direction (DR2) est inférieure à la première largeur (w1).

5. Dispositif d'affichage (1) selon l'une quelconque des revendications précédentes, dans lequel les parties larges (SG) formées sur chacune d'au moins deux lignes de signal (DL) adjacentes l'une à l'autre dans la seconde direction (DR2) sont espacées l'une de l'autre.

6. Dispositif d'affichage (1) selon la revendication 4, dans lequel la première largeur (w1) va de 2 µm à 3 µm.

7. Dispositif d'affichage (1) selon l'une quelconque des revendications précédentes, dans lequel la pluralité de parties larges (SG) présente une forme polygonale, et tous les angles intérieurs de la pluralité de parties larges (SG) sont des angles obtus ; et/ou dans lequel des coins de chacune de la pluralité de parties larges (SG) sont arrondis.

8. Dispositif d'affichage (1) comprenant :
un substrat (10) ;
des pixels disposés sur le substrat (10) ; et
une pluralité de lignes de signal (DL) permettant d'appliquer un signal aux pixels sur une ou plusieurs lignes de signal (DL) de la pluralité de lignes de signal (DL), comprenant une première ligne (DL1) et une seconde ligne (DL2) disposées sur le substrat (10), s'étendant parallèlement à une première direction (DR1)'
dans lequel la première ligne (DL1) inclut une première partie large (SG1) faisant saillie à partir de la première ligne (DL1) dans une seconde direction (DR2) traversant la première direction (DR1)'
dans lequel la seconde ligne (DL2) inclut une seconde partie large (SG2) faisant saillie à partir de la seconde ligne (DL2) dans la seconde direction (DR2)'
**caractérisé en ce que** la première ligne et la seconde ligne sont formées en différentes couches, et **en ce que**
la première partie large (SG1) de la première ligne (DL1) et la seconde partie large (SG2) de la seconde ligne (DL2) adjacentes l'une à l'autre forment un motif d'identification permettant d'identifier des numéros de ligne de la pluralité de lignes de signal (DL).

9. Dispositif d'affichage (1) selon la revendication 8, dans lequel la seconde ligne (DL2) chevauche au moins partiellement la première ligne (DL2), et
une couche isolante (IL1, IL2, IL3) est interposée entre la première ligne (DL1) et la seconde ligne (DL2).

10. Dispositif d'affichage (1) selon la revendication 8 ou 9, dans lequel la première ligne (DL1) et la première partie large (SG1) sont formées d'un seul tenant, et
la seconde ligne (DL2) et la seconde partie large (SG2) sont formées d'un seul tenant.

11. Dispositif d'affichage (1) selon l'une quelconque des revendications 8 à 10, dans lequel au moins une partie de la première partie large (SG1) et au moins une partie de la seconde partie large (SG2) se chevauchent dans une direction d'épaisseur (DR3).

12. Dispositif d'affichage (1) selon l'une quelconque des revendications 8 à 11, dans lequel le motif d'identification est un motif en relief ; et/ou dans lequel le motif d'identification est l'un parmi un symbole, une lettre, un nombre et un motif.

13. Dispositif d'affichage (1) selon l'une quelconque des revendications 8 à 12, dans lequel une orientation du motif d'identification est parallèle à la première direction (DR1).

14. Dispositif d'affichage (1) selon l'une quelconque des revendications 8 à 13, dans lequel la première ligne (DL1) et la seconde ligne (DL2) sont espacées l'une de l'autre d'une première largeur (w1) dans la seconde direction (DR2), et
dans lequel une largeur (w6) de la seconde partie large (SG2) dans la seconde direction (DR2) est supérieure à celle de la première largeur (w1).

15. Dispositif d'affichage (1) selon l'une quelconque des revendications 8 à 14, dans lequel la première ligne (DL1) s'étend à travers un centre de la première partie large (SG1), et
la seconde ligne (DL2) s'étend à travers un centre de la seconde partie large (SG2).
